(19) Europäisches Patentamt
European Patent Office
Office européen des brevets

(11) EP 4 661 057 A1

(12) **EUROPEAN PATENT APPLICATION**
published in accordance with Art. 153(4) EPC

(43) Date of publication:
**10.12.2025 Bulletin 2025/50**

(21) Application number: **24750007.7**

(22) Date of filing: **22.01.2024**

(51) International Patent Classification (IPC):
***H01L 21/304*** *(2006.01)* ***C09J 4/02*** *(2006.01)*
***C09J 5/00*** *(2006.01)* ***H01L 21/683*** *(2006.01)*

(52) Cooperative Patent Classification (CPC):
**C09J 4/00; C09J 5/00; H01L 21/304; H01L 21/683**

(86) International application number:
**PCT/JP2024/001572**

(87) International publication number:
**WO 2024/162054 (08.08.2024 Gazette 2024/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.01.2023 JP 2023013526**

(71) Applicant: **Denka Company Limited**
**Tokyo 103-8338 (JP)**

(72) Inventors:
- **TANIGAWA HOSHINO, Takako**
  **Tokyo 103-8338 (JP)**
- **TAKAHASHI, Yusuke**
  **Tokyo 103-8338 (JP)**
- **YAMAMOTO, Shota**
  **Tokyo 103-8338 (JP)**
- **KURIMURA, Hiroyuki**
  **Tokyo 103-8338 (JP)**

(74) Representative: **Hoffmann Eitle**
**Patent- und Rechtsanwälte PartmbB**
**Arabellastraße 30**
**81925 München (DE)**

(54) **METHOD FOR MANUFACTURING PLURALITY OF THIN WAFERS**

(57) An object of the present invention is to provide a method for manufacturing a plurality of thin wafers, the method being capable of cleaning a support member without providing a layer containing carbon black. The object can be solved by a method for manufacturing a plurality of thin wafers, the method including: a step (1) of bonding a substrate of a thin wafer and an optically transparent support member via a composition containing (A) polymerizable component containing (meth)acrylate, (B) photoradical polymerization initiator, and (C) ultraviolet absorber having a polymerizable functional group; a step (2) of irradiating light having a wavelength of 350 nm to 700 nm from the support member side to cure the composition to form an adhesive layer, and bonding the substrate and the support member; a step (3) of processing a surface of the substrate to form a thin wafer; a step (4) of irradiating light having a wavelength of 385 nm or less from the support member side to decompose the adhesive layer and peel the thin wafer from the support member; a step (5) of cleaning the support member for use in manufacturing a next thin wafer; and a step (6) of repeating the steps (1) to (5) at least once, in which in the step (1), a layer containing carbon black is not interposed between the substrate and the support member.

EP 4 661 057 A1

## Description

### Technical Field

The present invention relates to a method for manufacturing a plurality of thin wafers.

### Background Art

In production of an electronic device, a wafer-type substrate having a thickness of about several hundred μm obtained by using an inorganic material represented by silicon as a substrate and performing processing such as insulation film formation, circuit formation, and thinning by grinding on a surface of the inorganic material is often used. However, since many substrates are made of a material that is brittle and easily cracked, a breakage prevention measure is required particularly in thinning by grinding. As this measure, conventionally, a method of applying a protective tape for temporary fixing, which can be peeled off after completion of a processing step, to a surface (also referred to as a back surface) opposite to a grinding target surface is adopted. This tape uses an organic resin film as the substrate, has flexibility, but has insufficient strength and heat resistance, and is not suitable for use in a step at a high temperature.

Therefore, a system has been proposed in which a substrate for the electronic device is bonded to a support member such as silicon or glass via an adhesive, to impart sufficient durability to conditions of a step of grinding the back surface or forming a back electrode. What is important at this time is an adhesive layer when bonding the substrate to the support member. This requires that the substrate can be bonded to the support member without gaps, and has sufficient durability to withstand subsequent steps, and finally that the thinned wafer can be easily peeled off from the support member, that is, temporarily fixed.

In processing of such a wafer, a spin coating step, a vacuum bonding and photocuring step, a thinning processing step by grinding and polishing, a high temperature treatment step, a laser peeling step, and a removal step of a temporary fixing agent (hereinafter may be referred to as a composition for temporary fixing) are mainly performed.

In the spin coating step, in order to uniformly form a film of the temporary fixing agent on the wafer, it is required that the temporary fixing agent has a suitable viscosity and is a Newtonian fluid (or has a shear viscosity independent of shear rate).

In the vacuum bonding/UV curing step, the temporary fixing agent is required to be capable of curing on the support member such as glass by light irradiation with ultraviolet rays (UV) or the like in a short time, and to generate less outgas (low outgassing properties).

In the thinning processing step by grinding and polishing, in order to avoid damage due to local application of a load of a grinding machine to the substrate, the temporary fixing agent is required to have appropriate hardness capable of preventing local sinking of the substrate while dispersing the load in a in-plane direction, and maintaining flatness. In addition, adhesiveness with the support member, an appropriately high elastic modulus to protect an edge, and chemical resistance are also required.

In the high temperature treatment step, the temporary fixing agent is required to have heat resistance capable of withstanding high temperature treatment in vacuum for a long time (for example, at 300°C or more for one hour or more).

In the laser peeling step, the temporary fixing agent is required to be peeled off at high speed by a laser such as a UV laser.

In the removal step, in addition to easy peelability that allows the substrate to be easily peeled from the support member, aggregation properties and easy cleanability for not leaving residues of the adhesive on the substrate after peeling are required.

Against this background, Patent Literature 1 discloses a method for manufacturing a semiconductor chip including providing a photothermal conversion layer between the semiconductor chip and a light transmissive support. The photothermal conversion layer is decomposed by irradiation with radiant energy such as laser light, and allows the semiconductor chip to be separated from the support without damaging the semiconductor chip. According to this invention, it is disclosed that chipping at the time of dicing can be effectively prevented.

### Citation List

#### Patent Literature

Patent Literature 1: JP 2005-159155 A

### Summary of Invention

Technical Problem

In the invention disclosed in Patent Literature 1, in order to convert the radiant energy into heat when the radiant energy is irradiated, the photothermal conversion layer includes carbon black as a light absorber. However, there is a problem that carbon black scatters at the time of operation of conveying the support or cleaning the support for reuse, after peeling. Since a clean environment is required in semiconductor manufacturing, scattering of the carbon black is not preferable.

The present invention has been completed in view of the above problems, and an object of the present invention is to provide, in one embodiment, a method for manufacturing a plurality of thin wafers, the method being capable of cleaning the support member without providing a layer containing carbon black.

Solution to Problem

As a result of intensive studies, the present inventor has found that by irradiating an adhesive layer having a specific composition with light of a specific wavelength without providing the layer containing carbon black between a substrate of a thin wafer and an optically transparent support member, the thin wafer can be peeled off from the support member, and a remaining adhesive layer can be easily cleaned. The present invention has been completed based on the above findings, and is exemplified below.

[1] A method for manufacturing a plurality of thin wafers, the method including:

a step (1) of bonding a substrate of a thin wafer and an optically transparent support member via a composition for temporary fixing containing the following components (A) to (C),

(A) polymerizable component containing (meth)acrylate,
(B) photoradical polymerization initiator, and
(C) ultraviolet absorber having a polymerizable functional group;

a step (2) of irradiating light having a wavelength of 350 nm to 700 nm from the support member side to cure the composition for temporary fixing to form an adhesive layer, and bonding the substrate and the support member;
a step (3) of processing a surface of the substrate to form a thin wafer;
a step (4) of irradiating light having a wavelength of 385 nm or less from the support member side to decompose the adhesive layer and peel the thin wafer from the support member;
a step (5) of cleaning the support member for use in manufacturing a next thin wafer; and
a step (6) of repeating the steps (1) to (5) at least once, in which
in the step (1), a layer containing carbon black is not interposed between the substrate and the support member.

[2] The method according to [1], in which the adhesive layer has a light transmittance of 95% or less at a wavelength of 385 nm when the adhesive layer has a thickness of 50 μm.
[3] The method according to [1] or [2], in which the component (A) contains one or more selected from the group consisting of 9,9-bis[4-(2-hydroxy $C_1$-$C_{20}$ alkoxy)phenyl]fluorene di(meth)acrylate, $C_1$-$C_{20}$ alkoxylated bisphenol A di(meth)acrylate, benzyl di(meth)acrylate, 1,3-bis(2-(meth)acryloyloxy $C_1$-$C_{20}$ alkyl)benzene, 2,2-bis(4-(meth)acryloxydiethoxyphenyl)propane, nonylphenoxypolyethyleneglycol (meth)acrylate, and structural isomers thereof.
[4] The method according to any one of [1] to [3], in which the component (B) is one or more selected from bis(2,4,6-trimethylbenzoyl)phenylphosphine oxide and 1-[9-ethyl-6-(2-methylbenzoyl)-9H-carbazole-3-yl]ethanone 1-(O-acetyloxime).
[5] The method according to any one of [1] to [4], in which the component (C) has one or more selected from the group consisting of a benzophenone skeleton, a triazole skeleton, a hydroxyphenyltriazine skeleton, and a phenol skeleton, and has a polymerizable functional group.
[6] The method according to any one of [1] to [5], in which the component (B) is contained in an amount of 0.01 to 5 parts by mass and the component (C) is contained in an amount of 0.01 to 15 parts by mass with respect to a total of 100 parts by mass of the component (A).
[7] A method for manufacturing a plurality of thin wafers, the method including:

a step (1) of bonding a substrate of a thin wafer and an optically transparent support member via a composition containing the following components (A) to (C),

(A) polymerizable component containing (meth)acrylate,
(B) polymerization initiator, and
(C) ultraviolet absorber having a polymerizable functional group;

a step (2) of irradiating light having a wavelength of 350 nm to 700 nm from the support member side to cure the composition to form an adhesive layer, and bonding the substrate and the support member;
a step (3) of processing a surface of the substrate to form a thin wafer;
a step (4) of irradiating light having a wavelength of 385 nm or less from the support member side to decompose the adhesive layer and peel the thin wafer from the support member;
a step (5) of cleaning the support member for use in manufacturing a next thin wafer; and
a step (6) of repeating the steps (1) to (5) at least once, in which
in the step (1), a layer containing carbon black is not interposed between the substrate and the support member.

Advantageous Effects of Invention

According to an embodiment of the present invention, it is possible to provide a method for manufacturing a plurality of thin wafers, the method being capable of cleaning a support member without providing a layer containing carbon black.

Description of Embodiments

Next, an embodiment of the present invention will be described in detail. It should be understood that the present invention is not limited to the following embodiments, and that design changes, improvements, and the like are appropriately made based on ordinary knowledge of those skilled in the art without departing from the spirit of the present invention.

Unless otherwise stated herein, numerical ranges are intended to include their upper and lower limits. In the present specification, (meth)acrylate refers to a compound having one or more (meth)acryloyl groups in one molecule. A monofunctional (meth)acrylate refers to a compound having one (meth)acryloyl group in one molecule. A polyfunctional (meth)acrylate refers to a compound having two or more (meth)acryloyl groups in one molecule. An n-functional (meth) acrylate refers to a compound having n (meth)acryloyl groups in one molecule. As a polymerizable functional group, the polyfunctional (meth)acrylate may have only an acryloyl group, may have only a methacryloyl group, or may have both the acryloyl group and the methacryloyl group. Further, for example, expressions such as "$C_1$-$C_{20}$" and "$C_{10}$-$C_{20}$" respectively mean a hydrocarbon group having 1 to 20 carbon atoms and a hydrocarbon group having 10 to 20 carbon atoms.

(1. Bonding of substrate and support member)

In one embodiment of the present invention, a step of bonding a substrate of a thin wafer and an optically transparent support member via a composition containing the following (A) to (C), preferably a composition for temporary fixing is performed.

(A) polymerizable component containing (meth)acrylate
(B) polymerization initiator, preferably photoradical polymerization initiator
(C) ultraviolet absorber having a polymerizable functional group

(1-1. Component (A))

The polymerizable component which is the component (A) contained in the composition for temporary fixing of the present embodiment plays a role of forming a (meth)acrylic polymerization skeleton. Further, the composition for temporary fixing of the present embodiment may contain a non-polymerizable component, but an amount of the non-polymerizable component is preferably 15 parts by mass or less, and more preferably less than 15 parts by mass, with respect to a total of 100 parts by mass of the non-polymerizable component and the component (A). Note that in the present specification, the "non-polymerizable component" is defined as a component other than the component (B), that is, a component that is not used in the art as the photoradical polymerization initiator.

The polymerizable component which is the component (A) contained in the composition for temporary fixing of the present embodiment contains a (meth)acryloyl group and plays the role of forming the (meth)acrylic polymerization skeleton. The polymerizable component is preferably a polymerizable organic compound component. The component (A) may preferably contain a compound having two or more (meth)acryloyl groups. The component (A) may be a monofunctional (meth)acrylate, a bifunctional (meth)acrylate, a trifunctional or higher polyfunctional (meth)acrylate, or a mixture

thereof. Further, the component (A) may preferably contain a combination of the polyfunctional (meth)acrylate and the monofunctional (meth)acrylate (more preferably, a combination of the bifunctional (meth)acrylate and the monofunctional (meth)acrylate).

Examples of the polyfunctional (meth)acrylate that can be contained in the component (A) include aromatic (meth)acrylates, alicyclic bifunctional (meth)acrylates, and mixtures thereof from the viewpoint of being able to provide a rigid structure. The component (A) may include an acyclic polyfunctional (meth)acrylate. The polyfunctional (meth) acrylate may be a monomer, a polymer, or a mixture thereof. A molecular weight of the polyfunctional (meth)acrylate monomer is preferably 900 or less, more preferably 700 or less, still more preferably 500 or less, and yet still more preferably 400 or less.

A weight average molecular weight of the polyfunctional (meth)acrylate polymer is preferably 5000 to 200000. When the weight average molecular weight of the polyfunctional (meth)acrylate polymer is 5000 or more, an appropriate viscosity can be obtained when the polyfunctional (meth)acrylate polymer is blended with another polymerizable component. When the weight average molecular weight of the polyfunctional (meth)acrylate polymer is 10000 or more, an appropriate thickening effect can be obtained. From this viewpoint, the weight average molecular weight of the polyfunctional (meth)acrylate polymer is more preferably 6000 or more, and still more preferably 7000 or more. When the weight average molecular weight of the component (A) is 200000 or less, good spin coatability with low shear rate dependency can be obtained. From this viewpoint, the weight average molecular weight of the polyfunctional (meth) acrylate polymer is more preferably 190000 or less, still more preferably 180000 or less, yet still more preferably 150000 or less, and particularly preferably 100000 or less.

A functional group equivalent of the polyfunctional (meth)acrylate polymer is preferably 500 to 20000, more preferably 700 to 10000, and most preferably 1000 to 7000.

Note that the weight average molecular weight of the polyfunctional (meth)acrylate polymer in the present specification is a value in terms of standard polystyrene measured by a gel permeation chromatography (GPC) method. Specifically, the weight average molecular weight is determined by preparing a calibration curve with commercially available standard polystyrene using tetrahydrofuran as a solvent and GPC system (SC-8010 manufactured by Tosoh Corporation) under the following conditions.

Flow rate: 1.0 ml/min
Set temperature: 40°C
Column configuration: TSK-GEL Multipore HXL-M $\varphi$ 7.8×300 mm (manufactured by Tosoh Corporation) exclusion limit 2 million 2 columns
Sample injection amount: 100 $\mu$l (sample liquid concentration 0.1% (wt/vol))
Liquid feeding pressure: 3.8MPa

Examples of the aromatic (meth)acrylate include one or more selected from the group consisting of 9,9-bis[4-(2-hydroxy $C_1$-$C_{20}$ alkoxy)phenyl]fluorene di(meth)acrylate, $C_1$-$C_{20}$ alkoxylated bisphenol A di(meth)acrylate, benzyl di(meth)acrylate, 1,3-bis(2-(meth)acryloyloxy $C_1$-$C_{20}$ alkyl)benzene, 2,2-bis(4-(meth)acryloxydiethoxyphenyl)propane (including ethoxylated bisphenol A di(meth)acrylate), nonylphenoxypolyethyleneglycol (meth)acrylate (including nonylphenol EO-modified (meth)acrylate), and structural isomers thereof. Preferably, a di(meth)acrylate having a condensed ring skeleton, for example, a skeleton of fluorene, indene, indecene, anthracene, azulene, or triphenylene may be included.

Examples of the alicyclic bifunctional (meth)acrylate include $C_1$-$C_{20}$ alkoxylated hydrogenated bisphenol A di(meth)acrylate, 1,3-di(meth)acryloyloxyadamantane, tricyclo $C_{10}$-$C_{20}$ alkane dimethanol di(meth)acrylate, dicyclo $C_3$-$C_{20}$ di(meth)acrylate, and structural isomers thereof.

Examples of the acyclic bifunctional (meth)acrylate include 1,3-butanediol di(meth)acrylate, 1,4-butanediol di(meth)acrylate, 1,6-hexanediol di(meth)acrylate, 1,9-nonanediol di(meth)acrylate, 1,10-decanediol di(meth)acrylate, neopentyl glycol di(meth)acrylate, neopentyl glycol-modified trimethylolpropane di(meth)acrylate, stearic acid-modified pentaerythritol di(meth)acrylate, tripropylene glycol di(meth)acrylate, and caprolactone-modified hydroxypivalic acid neopentyl glycol di(meth)acrylate.

Further, the component (A) may contain trifunctional or higher polyfunctional (meth)acrylate. Examples of the trifunctional (meth)acrylate include isocyanuric acid ethylene oxide-modified tri(meth)acrylate, pentaerythritol tri(meth) acrylate, trimethylolpropane tri(meth)acrylate, and tris[(meth)acryloyloxyethyl]isocyanurate.

Examples of the tetrafunctional or higher polyfunctional (meth)acrylate include ditrimethylolpropane tetra(meth) acrylate, dimethylolpropane tetra(meth)acrylate, pentaerythritol tetra(meth)acrylate, pentaerythritol ethoxy tetra(meth) acrylate, dipentaerythritol penta(meth)acrylate, and dipentaerythritol hexa(meth)acrylate.

Further, as the monofunctional (meth)acrylate which may be contained in the component (A), a monofunctional (meth)acrylate having a molecular weight of 550 or less is preferable, and a monofunctional alkyl(meth)acrylate having an alkyl group is more preferable.

The alkyl group is preferably one or more selected from a linear alkyl group, a branched alkyl group, and an alicyclic alkyl group, and more preferably one or more selected from the linear alkyl group and the branched alkyl group. From the viewpoint of improving compatibility with other components, the component (A) preferably has a long-chain and branched or cyclic alkyl group, and for example, preferably has a branched alkyl group having, for example, 18 to 40 carbon atoms, more preferably 18 to 32 carbon atoms, such as an isostearyl group, an isotetracosanyl group (2-decyl-1-tetradecanyl group or the like), or an isotriacontanyl group (2-tetradecyl-1-octadecanyl group or the like), or a cycloalkyl group. By using such a component having a long chain, a high molecular weight, and a strong character of an aliphatic hydrocarbon (more preferably, by increasing aliphatic hydrocarbon properties of an entire system), low volatility, chemical resistance, and heat resistance required for the composition for temporary fixing can be improved.

The component (A) is preferably one or more selected from the group consisting of stearyl (meth)acrylate, isostearyl (meth)acrylate, behenyl (meth)acrylate, 2-decyl-1-tetradecanyl (meth)acrylate, 2-dodecyl-1-hexadecanyl (meth)acrylate, and 2-tetradecyl-1-octadecanyl (meth)acrylate. As the component (A), a (meth)acrylate of the following formula 1 is preferable.

[Formula 1]

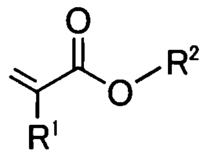

Formula

In the formula, $R^1$ is a hydrogen atom or a methyl group, and more preferably the hydrogen atom. $R^2$ is an alkyl group, and the number of carbon atoms is preferably 18 to 32. One or more of these (meth)acrylates can be used.

The monofunctional alkyl(meth)acrylate in which $R^2$ is an alkyl group having 18 to 32 carbon atoms is preferably a (meth)acrylate having a linear or branched alkyl group, such as stearyl (meth)acrylate, isostearyl (meth)acrylate, nonadecyl (meth)acrylate, eicodecyl (meth)acrylate, behenyl (meth)acrylate, 2-decyl-1-tetradecanyl (meth)acrylate, or 2-tetradecyl-1-octadecanyl (meth)acrylate.

The content of the component (A) is preferably 60 to 100 mass%, 70 to 98 mass%, 80 to 96 mass%, or 85 to 94 mass%, with respect to a total amount of the composition for temporary fixing.

In a preferred embodiment, the amount of the non-polymerizable component contained in the composition for temporary fixing of the present embodiment may be 0 mass% or more and less than 10 mass%, or 0 mass% or more and less than 5 mass%. More preferably, the composition for temporary fixing of the present embodiment may not contain the non-polymerizable component except the component (B).

(1-2. Component (B))

The polymerization initiator, preferably the photoradical polymerization initiator, which is the component (B) contained in the composition for temporary fixing of the present embodiment is a substance capable of initiating polymerization of the component (A) upon light irradiation. The photoradical polymerization initiator refers to, for example, a compound in which molecules are disconnected and divided into two or more radicals by irradiation with ultraviolet rays or visible light (for example, wavelength of 350 to 700 nm, preferably 365 to 500 nm, more preferably 385 to 450 nm). Examples of the photoradical polymerization initiator include bis(2,4,6-trimethylbenzoyl)phenylphosphine oxide, 2,4,6-trimethylbenzoyldiphenylphosphine oxide, bis(η5-2,4-cyclopentadiene-1-yl)-bis(2,6-difluoro-3-(1H-pyrrole-1-yl)-phenyl) titanium, 2-benzyl-2-dimethylamino-1-(4-morpholinophenyl)-butane-1-one, 2-dimethylamino-2-(4-methylbenzyl)-1-(4-morpholine-4-ylphenyl)-butane-1-one, 1-[4-(phenylthio)phenyl]-1,2-octanedione-2-O-benzoyloxime, and 1-[9-ethyl-6-(2-methylbenzoyl)-9H-carbazole-3-yl]ethanone 1-(O-acetyloxime). The component (B) may include one or more of these, or a combination of two or more thereof.

In the preferred embodiment of the present invention, the component (B) contained in the composition for temporary fixing may contain an acylphosphine oxide-based compound. Preferred acylphosphine oxide-based compounds include bis(2,4,6-trimethylbenzoyl)phenylphosphine oxide and 2,4,6-trimethylbenzoyldiphenylphosphine oxide. It is preferable that the photoradical polymerization initiator has high sensitivity, and excellent deep curability because of having light fading property, and in addition, an absorption wavelength region for generating radicals extends to a relatively long wavelength region. In the preferred compound described above, the absorption wavelength region is in a range up to a wavelength of about 440 nm, and a difference from the absorption wavelength region of a UV absorber used in a UV laser

peeling step described later is large. That is, the degree of UV curing inhibition by the UV absorber is small, and radical polymerization can be initiated by light having a longer wavelength. Therefore, it is possible to obtain an effect that the radical polymerization can be efficiently initiated and cured at a relatively high speed even in the presence of the UV absorber.

In the preferred embodiment, the photoradical polymerization initiator can be selected from absorbance. Specifically, the photoradical polymerization initiator can be selected from one or more kinds of compounds that satisfy any one or more of the following conditions: absorbance at a wavelength of 365 nm is 0.5 or more; absorbance at a wavelength of 385 nm is 0.5 or more; and absorbance at a wavelength of 405 nm is 0.5 or more, when dissolved at a concentration of 0.1 mass% in a solvent (for example, acetonitrile, toluene, or the like) having no maximum absorption in a wavelength region of 300 to 500 nm. Examples of the compounds satisfying such conditions include, when dissolved at a concentration of 0.1 mass% with respect to acetonitrile as the solvent, 1-[9-ethyl-6-(2-methylbenzoyl)-9H-carbazole-3-yl] ethanone 1-(O-acetyloxime) having an absorbance of 0.5 or more at a wavelength of 365 nm, 1-[4-(phenylthio) phenyl]-1,2-octanedione-2-O-benzoyloxime having an absorbance of 0.5 or more at wavelengths of 365 nm and 385 nm, and bis(2,4,6-trimethylbenzoyl)phenylphosphine oxide and 2,4,6-trimethylbenzoyldiphenylphosphine oxide having an absorbance of 0.5 or more at wavelengths of 365 nm, 385 nm, and 405 nm.

From the viewpoint of achieving both curability by the photoradical polymerization initiator and UV laser peeling, bis(η5-2,4-cyclopentadiene-1-yl)-bis(2,6-difluoro-3-(1H-pyrrole-1-yl)-phenyl)titanium having an absorption wavelength region in a range of 400 to 500 nm can also be used as the photoradical polymerization initiator.

The photoradical polymerization initiator (B) is preferably one or more selected from an acylphosphine oxide-based compound, a titanocene-based compound, and an α-aminoalkylphenone-based compound in terms of having reaction rate, heat resistance after curing, low outgassing properties, and absorption characteristics in a region different from both a wavelength of the UV laser used in the UV laser peeling described below and the absorption wavelength region of the UV absorber used in the UV laser peeling. In addition to the above, an oxime ester-based compound can also be selected as the photoradical polymerization initiator for a resin composition for temporary fixing use of preventing damage from bonding to the support member of the substrate to be processed to a heating step, which is not a layer corresponding to the UV laser peeling step, in the composition for temporary fixing having a structure described later.

Examples of the acylphosphine oxide-based compound include bis(2,4,6-trimethylbenzoyl)phenylphosphine oxide and 2,4,6-trimethylbenzoyldiphenylphosphine oxide. Among them, bis(2,4,6-trimethylbenzoyl)phenylphosphine oxide is particularly preferable.

Examples of the titanocene-based compound include bis(η5-2,4-cyclopentadiene-1-yl)-bis(2,6-difluoro-3-(1H-pyrrole-1-yl)-phenyl)titanium.

Examples of the α-aminoalkylphenone-based compound include 2-benzyl-2-dimethylamino-1-(4-morpholinophenyl)-butane-1-one and 2-dimethylamino-2-(4-methylbenzyl)-1-(4-morpholine-4-ylphenyl)-butane-1-one.

Examples of the oxime ester-based compound include 1-[4-(phenylthio)phenyl]-1,2-octanedione-2-O-benzoyloxime and 1-[9-ethyl-6-(2-methylbenzoyl)-9H-carbazole-3-yl]ethanone 1-(O-acetyloxime). Among them, 1-[9-ethyl-6-(2-methylbenzoyl)-9H-carbazole-3-yl]ethanone 1-(O-acetyloxime) is preferred.

In the preferred embodiment of the present invention, the component (B) in the composition for temporary fixing is one or more selected from bis(2,4,6-trimethylbenzoyl)phenylphosphine oxide, 2,4,6-trimethylbenzoyldiphenylphosphine oxide, and 1-[9-ethyl-6-(2-methylbenzoyl)-9H-carbazole-3-yl]ethanone 1-(O-acetyloxime).

An amount of the photoradical polymerization initiator (B) used is preferably 0.01 to 5 parts by mass, more preferably 0.01 to 3 parts by mass, still more preferably 0.1 to 2 parts by mass, and yet still more preferably 0.1 to 1 part by mass, with respect to a total of 100 parts by mass of the component (A) in terms of the reaction rate, the heat resistance after curing, and the low outgassing properties. When the component (B) is 0.01 parts by mass or more, sufficient curability is obtained, and when the component (B) is 5 parts by mass or less, an effect that the low outgassing properties and the heat resistance are less likely to be impaired is obtained.

(1-3. Component (C))

The ultraviolet absorber (UV absorber) having a polymerizable functional group, which is the component (C) contained in the composition for temporary fixing of the present embodiment, refers to a compound in which molecules are disconnected by irradiation with a laser of ultraviolet rays or visible light to be decomposed and vaporized, and the decomposition and vaporization are generated at an interface between the support member and the temporary fixing agent, thereby losing adhesiveness between the temporary fixing agent and the support member that has been maintained until immediately before the UV laser peeling step. The component (C) is a compound having one or more selected from the group consisting of a benzophenone skeleton, a triazole skeleton, a hydroxyphenyltriazine skeleton, and a phenol skeleton (preferably a hindered phenol skeleton). The reason for having these skeletons is to obtain the degree of overlap with a UV laser wavelength in a UV absorption wavelength region, UV absorption characteristics at the same wavelength, the low outgassing properties, and the heat resistance. The polymerizable functional group of the component

(C) is preferably a (meth)acryloyl group.

As an example of the component (C), one or more selected from the group consisting of 2-[2-hydroxy-5-[2-((meth)acryloyloxy)ethyl]phenyl]-2H-benzotriazole, 2-[1-(2-hydroxy-3,5-di-tert-pentylphenyl)ethyl]-4,6-di-tert-pentylphenyl (meth)acrylate, 2-(2-(meth)acryloyloxy,5-methyl)phenyl-2H-benzotriazole, 1,1-bis-[2-(meth)acryloyloxy,3-(2H-benzotriazole-2-yl),5-tertiary octyl]methane, and 2,2'-dihydroxy-4,4'-di(meth)acryloyloxybenzophenone are particularly preferable in terms of compatibility with a resin component, the UV absorption characteristics, the low outgassing properties, and the heat resistance.

An amount of the component (C) is preferably 0.01 to 15 parts by mass, more preferably 0.1 to 12 parts by mass, still more preferably 0.5 to 10 parts by mass, still more preferably 0.5 to 9 parts by mass, and yet still more preferably 0.5 to 7 parts by mass, with respect to the total of 100 parts by mass of the component (A). When the component (C) is 0.01 parts by mass or more, a sufficient UV laser peeling rate is obtained, and when the component (C) is 15 parts by mass or less, the effect that the low outgassing properties and the heat resistance are less likely to be impaired is obtained.

(1-4. Application of composition for temporary fixing)

A method for bonding the substrate of the thin wafer and the optically transparent support member is not particularly limited, but is typically performed by applying a temporary fixing adhesive to the optically transparent support member and then bonding the substrate to a surface to which the temporary fixing adhesive has been applied.

As a method for applying the temporary fixing adhesive, known application methods such as spin coating, screen printing, and various coaters can be used. A viscosity of the composition for temporary fixing of the present embodiment is preferably 500 mPa·s or more, and more preferably 1000 mPa·s or more in terms of coatability and workability at 23°C (under atmospheric pressure). The viscosity of the composition for temporary fixing of the present embodiment is preferably 15000 mPa·s or less, more preferably 10,000 mPa·s or less, and still more preferably 5000 mPa·s or less in terms of coatability and workability at 23°C (under atmospheric pressure). When the viscosity is 500 mPa·s or more, the coatability, particularly the coatability by spin coating are excellent. When the viscosity is 15000 mPa·s or less, the workability is excellent. The viscosity can be measured by a known viscometer.

The spin coating is, for example, a method in which a liquid composition is dropped on the support member and the support member is rotated at a predetermined rotation speed to apply the composition to a surface of the support member. By the spin coating, a high-quality coating film can be efficiently produced.

(2. Adhesion between substrate and support member)

When the substrate to be processed and the support member are bonded, the composition for temporary fixing is irradiated with light having a wavelength of 350 nm to 700 nm to be cured to form an adhesive layer. In particular, it is preferable to perform irradiation with visible light or ultraviolet rays (wavelength or center wavelength: 365 to 405 nm) so that an energy amount is 1 to 20000 $mJ/cm^2$. When the energy amount is 1 $mJ/cm^2$ or more, sufficient adhesiveness is obtained, and when the energy amount is 20000 $mJ/cm^2$ or less, productivity is excellent, a decomposition product from the photoradical polymerization initiator is less likely to be generated, and generation of outgas is suppressed. It is preferably 1000 to 10000 $mJ/cm^2$ in terms of the productivity, the adhesiveness, the low outgassing properties, and the easy peelability.

The support member is not particularly limited, but is preferably optically transparent. Examples of transparent substrates include inorganic substrates such as crystal, glass, quartz, calcium fluoride, and magnesium fluoride, and organic substrates such as plastic. Among them, the inorganic substrates are preferable in terms of having versatility and obtaining a large effect. Among the inorganic substrates, one or more selected from glass and quartz are preferable.

(3. Processing of substrate)

After bonding the substrate to be processed and the support member, a step of processing a surface of the substrate to form the thin wafer is performed. The content of processing is not particularly limited, but typically includes thinning processing by grinding and polishing, high temperature processing, and the like.

(4. Decomposition of adhesive layer)

By the above-mentioned step of bonding the substrate and the support member, the composition for temporary fixing is cured to form the adhesive layer. After the thin wafer is formed, a step of decomposing the adhesive layer by irradiating light having a wavelength of 385 nm or less, more preferably 300 nm to 385 nm from the support member side is performed. For example, the adhesive layer can be decomposed by irradiating an entire surface of the thin wafer with a UV laser having a wavelength of 300 nm to 385 nm in a scanning manner.

When the adhesive layer is decomposed, the thin wafer can be peeled off from the support member. Here, since there is no layer containing carbon black between the substrate of the thin wafer and the support member, there is no possibility that the carbon black scatters even if both are peeled off.

In order to promote decomposition of the adhesive layer, it is preferable that the adhesive layer has a light transmittance of 95% or less at a wavelength of 385 nm when the adhesive layer has a thickness of 50 μm. The light transmittance of the adhesive layer is preferably 50% or less within a wavelength range of 350 nm to 385 nm. By satisfying this condition, both the peeling rate and peeling effect can be achieved. From this viewpoint, the light transmittance of the adhesive layer at a wavelength of 385 nm is more preferably 45% or less, still more preferably 40% or less, still more preferably 30% or less, and yet still more preferably 20% or less.

The light transmittance in the present specification is a value obtained by absorptiometry. Specifically, the transmittance is measured under the following conditions. Using a laminate obtained by sandwiching and curing the composition for temporary fixing having the same composition as that of the adhesive layer and having a thickness of 50 μm between glasses (thickness of 700 μm), measurement is performed under the following conditions using an ultraviolet visible spectrophotometer (UV 2550 manufactured by Shimadzu Corporation) with a transmittance of one glass (thickness of 700 μm) as a reference. Note that the transmittance of one glass (thickness of 700 μm) is used as the reference.

Photometry mode: transmission
Measurement range: 800 to 200 nm
Data capture interval: 1 nm
Light source: D2/WI
Wavelength feed speed: medium speed

Note that when the thickness cannot be adjusted to 50 μm, a value of transmittance $y_\alpha$% at an actually measured thickness (assumed to be α μm) is used, and transmittance $y_{50}$(%) at a thickness of 50 μm is calculated by the following formula.

$$y_{50}(\%) = 100 \times (y_\alpha/100)^{(50/\alpha)}$$

(5. Cleaning of support member)

After the thin wafer is peeled from the support member, the adhesive layer may remain on the surface of the thin wafer. Therefore, a step of cleaning the support member is performed for use in production of a next thin wafer.

The support member can be cleaned by brushing the support member with a brush (for example, a commercially available toothbrush) soaked in ammonia water, 2-methoxy-1-methylethyl acetate, or an organic solvent such as isopropylene alcohol or acetone. As described above, since there is no layer containing carbon black between the substrate of the thin wafer and the support member, there is no possibility that carbon black scatters even if the support member is cleaned. Further, the cleaning can also be performed by wiping with a waste cloth soaked with ammonia water, 2-methoxy-1-methylethyl acetate, or the organic solvent such as isopropylene alcohol or acetone. Furthermore, the cleaning can also be performed with the brush while pouring these liquids. Rotating the brush, the substrate, or both have the same effect as the above brushing.

The support member after cleaning can be used for manufacturing the next thin wafer. By repeating each of the above-described steps one or more times, it is possible to further manufacture a plurality of thin wafers.

Examples

Hereinafter, the present invention will be described in more detail based on Examples and Comparative Examples, but the present invention is not limited thereto.

Experiments were performed at 23°C and a humidity of 50% unless otherwise specified. A temporary curing composition (hereinafter may be referred to as a liquid composition) having a composition (unit: part(s) by mass) shown in the following table was prepared and evaluated. As the components, the following compounds were selected.

(Composition)

As the component (A), the following were used.

APB-001 (polyfunctional acrylate polymer, "APB-001" manufactured by Negami Chemical Industrial Co., Ltd., weight

average molecular weight: 72,000, functional group equivalent: 1400)

RC110C (both ends acrylate polymer, "XMAP RC110C" manufactured by KANEKA CORPORATION, weight average molecular weight 12,000, functional group equivalent 6,000)

A-BPEF-2: 9,9-bis[4-(2-hydroxyethoxy)phenyl]fluorene diacrylate ("NK Ester A-BPEF-2" manufactured by Shin Nakamura Chemical Co., Ltd.)

A-BPE-2: ethoxylated bisphenol A diacrylate ("NK Ester A-BPE-2" manufactured by Shin Nakamura Chemical Co., Ltd., R=$-CH_2CH_2O-$, m=n=1 in the following structural formula)

[Formula 2]

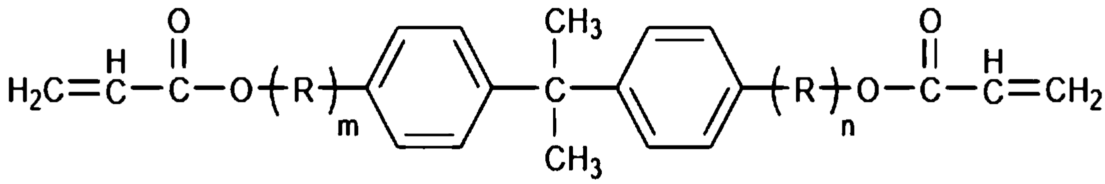

HBPE-4: EO (ethylene oxide)-modified hydrogenated bisphenol A diacrylate ("HBPE-4" manufactured by DKS Co. Ltd., m+n≈4)

A-DOD-N: 1,10-decanediol diacrylate ("A-DOD-N" manufactured by Shin-Nakamura Chemical Co., Ltd.)

HX-620: caprolactone-modified hydroxypivalic acid neopentyl glycol diacrylate ("KAYARAD HX-620" manufactured by Nippon Kayaku Co., Ltd., m+n≈4)

HX-220: caprolactone-modified hydroxypivalic acid neopentyl glycol diacrylate ("KAYARAD HX-220" manufactured by Nippon Kayaku Co., Ltd., m+n≈2)

A-TMPT: trimethylolpropane triacrylate ("A-TMPT" manufactured by Shin-Nakamura Chemical Co., Ltd.)

M-113: nonylphenol EO-modified acrylate ("ARONIX M-113" manufactured by Toagosei Co., Ltd., n≈4)

ISTA: isostearyl acrylate ("ISTA" manufactured by OSAKA ORGANIC CHEMICAL INDUSTRY LTD.)

As the component (B), bis(2,4,6-trimethylbenzoyl)phenylphosphine oxide ("Omnirad 819" manufactured by IGM RESINS) was used.

As the component (C), the following were used.

RUVA-93: 2-[2-hydroxy-5-[2-(methacryloyloxy)ethyl]phenyl]-2H-benzotriazole ("RUVA-93" manufactured by Otsuka Chemical Co., Ltd.)

P-66: 2,2'-dihydroxy-4,4'-diacryloyloxybenzophenone ("DAINSORB P-66" manufactured by Daiwa Fine Chemicals Co., Ltd.)

(Measurement of light transmittance)

For the composition for temporary fixing of each of Comparative Examples and Examples shown in Table 1, the light transmittance at a wavelength of 385 nm was measured by the above-described method. Results are shown in Table 1. Specifically, using the laminate obtained by sandwiching and curing the composition for temporary fixing having the same composition as that of the adhesive layer and having a thickness of 50 μm between glasses (thickness of 700 μm), the measurement was performed by setting the following conditions using the ultraviolet visible spectrophotometer (UV 2550 manufactured by Shimadzu Corporation) with the transmittance of one glass (thickness of 700 μm) as the reference. Note that the transmittance of one glass (thickness of 700 μm) was used as the reference.

Photometry mode: transmission
Measurement range: 800 to 200 nm
Data capture interval: 1 nm
Light source: D2/WI
Wavelength feed speed: medium speed

(Preparation of liquid sample)

As shown in Table 1, for each of Comparative Examples and Examples, materials were heated and mixed at 60°C to obtain the composition for temporary fixing as a uniform liquid composition.

(Preparation of bonding samples of Examples)

A 4 inch silicon wafer (diameter 10 cm×thickness 0.47 mm) and a 4 inch glass support member (diameter 10 cm×thickness 0.7 mm) were bonded to each other using the prepared liquid composition. In the bonding, the thickness of the composition was adjusted to 50 μm. After the bonding, the composition was cured by an LED having a wavelength of 405 nm under a condition of an integrated light amount of 5000 mJ/$cm^2$ to prepare a test piece for evaluating adhesiveness under a high temperature condition. The composition was applied to an entire surface of a bonding surface.

Further, the viscosity of the prepared liquid composition was measured according to JIS Z 8803:2011 using the following apparatus.

(Evaluation of viscosity)

Measuring apparatus: E-type viscometer DV3T-HB (manufactured by EKO Instruments Co., Ltd.)
Measuring jig: cone plate CPA-40Z (manufactured by EKO Instruments Co., Ltd.)
Measurement temperature: 23°C
Rotation speed: 10rpm

(Evaluation of cleanability)

The glass was peeled off by irradiating the UV laser with a wavelength of 355 nm onto a perfect circular area with a diameter of 110 mm fixed at a center of the obtained 4-inch test specimen from the glass support member side so as to scan an entire surface of the test specimen. As the UV laser, a UV laser QLA-355 manufactured by Quark Technology Co., Ltd. was used at an output of 8.5 W, a frequency of 40 kHz, a scan pitch of 200 μm, and a beam diameter of 200 μm.

Next, after the glass support member was peeled off, brushing was performed 10 times from a center side to an outer peripheral side of the glass support member using a commercially available brush immersed in 5 mass% ammonia water, and a state of the surface of the glass support member was checked. The quality of cleanability was determined according to the following criteria.

⊙: light is applied and no dirt is visually confirmed

◦: no dirt remains visually under fluorescent light

×: visually confirmed that dirt remains

[Table 1]

| | | Example 1 | Example 2 | Example 3 | Example 4 | Example 5 | Example 6 |
|---|---|---|---|---|---|---|---|
| (A) | APB-001 | | | 10 | 15 | 15 | |
| | RC110C | - | - | | | | 30 |
| | A-BPEF-2 | 10 | 10 | 15 | 10 | 10 | 10 |
| | A-BPE-2 | 22.5 | 22.5 | 25 | | | 15 |
| | HBPE-4 | | | | 25 | 25 | |
| | A-DOD-N | | | | 10 | 10 | |
| | HX-620 | 67.5 | 67.5 | | | | |
| | HX-220 | | | | | | 7.5 |
| | A-TMPT | | | | | | 7.5 |
| | M-113 | | | 20 | 10 | 10 | 10 |
| | ISTA | | | 30 | 30 | 30 | 20 |
| (B) | Omnirad 819 | 1 | 1 | 1 | 1 | 1 | 1.5 |

(continued)

| | | Example 1 | Example 2 | Example 3 | Example 4 | Example 5 | Example 6 |
|---|---|---|---|---|---|---|---|
| (C) | RUVA-93 | 5.0 | 3.0 | 4.0 | 5.0 | 3.5 | 3.5 |
| | P-66 | 4.0 | 0.0 | 4.0 | 4.0 | 5.5 | 5.0 |
| Evaluation results | Viscosity (mPa·s) | 900 | 900 | 2300 | 1400 | 1400 | 1900 |
| | Transmittance (%) (385 nm) | 11 | 93 | 25 | <1 | <1 | <1 |
| | Cleanability | ⊙ | ○ | ⊙ | ⊙ | ⊙ | ⊙ |

The unit of the amount used is parts by mass.

From the results in Table 1, it can be seen that in a manufacturing method of the present invention, a remaining adhesive layer could be easily cleaned without providing a layer containing carbon black. This enables work in a cleaner environment.

(Preparation of bonding sample of Comparative Example)

A carbon black liquid (see Table 2) prepared as Comparative Example 1 was applied to a 4 inch glass support member (diameter 10 cm×thickness 0.7 mm) by spin coating. This was dried by heating, and irradiated with ultraviolet rays (UV) of 1500 mJ/cm$^2$ (wavelength 365 nm) to form a carbon black layer. On the other hand, the temporary fixing agent (see Table 2) prepared as Comparative Example 1 was applied to a 4 inch silicon wafer (diameter 10 cm×thickness 0.47 mm), and bonded to a glass support member. At this time, a bonding surface on the glass support member side was a side on which the carbon black layer was formed. In bonding, the thickness of the temporary fixing agent was adjusted to 50 μm. After bonding, the agent was cured under conditions of ultraviolet rays (UV) irradiation at 1500 mJ/cm$^2$ (wavelength: 365 nm) to prepare a sample. The temporary fixing agent was applied to the entire surface of the bonding surface.

(Composition)

UV6100B: urethane acrylate (manufactured by Nippon Synthetic Chemical Industry Co., Ltd.)
1,6-HX-A: 1,6-hexanediol diacrylate (manufactured by Kyoeisha Chemical Co., Ltd.)
Omnirad 369: photoradical polymerization initiator (manufactured by IGM RESINS)
Sevacarb: carbon black (manufactured by Columbian carbon black Co., Ltd.)
AEROSIL A200: silica (manufactured by Nippon Aerosil Co., Ltd.)
Disperbyk161: dispersant (manufactured by BYK Japan KK)
Joncryl 690: acrylic resin (manufactured by Johnson Polymer Co., Ltd.)
Propylene glycol: commercial product

(Evaluation of cleanability)

The glass was peeled off by irradiating an IR laser onto the perfect circular area with a diameter of 110 mm fixed at the center of the obtained 4-inch test specimen from the glass support member side so as to scan the entire surface of the test specimen. As the IR laser, a YAG laser (wavelength: 1064 nm) was used at an output of 7.0 W and a scan pitch of 130 μm.

Next, after the glass support member was peeled off, brushing was performed 10 times from a center side to an outer peripheral side of the glass support member using a commercially available brush immersed in 5 mass% ammonia water, and a state of the surface of the glass support member was checked. The quality of the cleanability was determined according to the following criteria.

⊙: light is applied and no dirt is visually confirmed
◦: no dirt remains visually under fluorescent light
×: visually confirmed that dirt remains

[Table 2]

| | | Comparative Example 1 |
|---|---|---|
| Temporary fixing agent | UV6100B | 60 |
| | 1, 6-HX-A | 40 |
| | Omnirad 369 | 5 |
| Carbon black liquid | Sevacarb | 25 |
| | AEROSIL A200 | 32.5 |
| | Disperbyk161 | 7.5 |
| | Joncryl 690 | 35 |
| | Propylene glycol | 900 |
| Evaluation results | Cleanability | × |
| The unit of the amount used is parts by mass. | | |

From the results in Table 2, in Comparative Example using carbon black, it was visually confirmed that black carbon black remained, and the cleanability was also poor.

## Claims

1. A method for manufacturing a plurality of thin wafers, the method comprising:

    a step (1) of bonding a substrate of a thin wafer and an optically transparent support member via a composition for temporary fixing containing the following components (A) to (C)

        (A) polymerizable component containing (meth)acrylate,
        (B) photoradical polymerization initiator, and
        (C) ultraviolet absorber having a polymerizable functional group;

    a step (2) of irradiating light having a wavelength of 350 nm to 700 nm from the support member side to cure the composition for temporary fixing to form an adhesive layer, and bonding the substrate and the support member;
    a step (3) of processing a surface of the substrate to form a thin wafer;
    a step (4) of irradiating light having a wavelength of 385 nm or less from the support member side to decompose the adhesive layer and peel the thin wafer from the support member;
    a step (5) of cleaning the support member for use in manufacturing a next thin wafer; and
    a step (6) of repeating the steps (1) to (5) at least once, wherein
    in the step (1), a layer containing carbon black is not interposed between the substrate and the support member.

2. The method according to claim 1, wherein the adhesive layer has a light transmittance of 95% or less at a wavelength of 385 nm when the adhesive layer has a thickness of 50 μm.

3. The method according to claim 1 or 2, wherein the component (A) contains one or more selected from the group consisting of 9,9-bis[4-(2-hydroxy $C_1$-$C_{20}$ alkoxy)phenyl]fluorene di(meth)acrylate, $C_1$-$C_{20}$ alkoxylated bisphenol A di(meth)acrylate, benzyl di(meth)acrylate, 1,3-bis(2-(meth)acryloyloxy $C_1$-$C_{20}$ alkyl)benzene, 2,2-bis(4-(meth)acryloxydiethoxyphenyl)propane, nonylphenoxypolyethyleneglycol (meth)acrylate, and structural isomers thereof.

4. The method according to claim 1 or 2, wherein the component (B) is one or more selected from bis(2,4,6-trimethylbenzoyl)phenylphosphine oxide and 1-[9-ethyl-6-(2-methylbenzoyl)-9H-carbazole-3-yl]ethanone 1-(O-acetyloxime).

5. The method according to claim 1 or 2, wherein the component (C) has one or more selected from the group consisting of a benzophenone skeleton, a triazole skeleton, a hydroxyphenyltriazine skeleton, and a phenol skeleton, and has a polymerizable functional group.

**6.** The method according to claim 1 or 2, wherein the component (B) is contained in an amount of 0.01 to 5 parts by mass and the component (C) is contained in an amount of 0.01 to 15 parts by mass with respect to a total of 100 parts by mass of the component (A).

**7.** A method for manufacturing a plurality of thin wafers, the method comprising:

a step (1) of bonding a substrate of a thin wafer and an optically transparent support member via a composition containing the following components (A) to (C),

(A) polymerizable component containing (meth)acrylate,
(B) polymerization initiator, and
(C) ultraviolet absorber having a polymerizable functional group;

a step (2) of irradiating light having a wavelength of 350 nm to 700 nm from the support member side to cure the composition to form an adhesive layer, and bonding the substrate and the support member;
a step (3) of processing a surface of the substrate to form a thin wafer;
a step (4) of irradiating light having a wavelength of 385 nm or less from the support member side to decompose the adhesive layer and peel the thin wafer from the support member;
a step (5) of cleaning the support member for use in manufacturing a next thin wafer; and
a step (6) of repeating the steps (1) to (5) at least once, wherein
in the step (1), a layer containing carbon black is not interposed between the substrate and the support member.

## INTERNATIONAL SEARCH REPORT

International application No.
**PCT/JP2024/001572**

### A. CLASSIFICATION OF SUBJECT MATTER

***H01L 21/304***(2006.01)i; ***C09J 4/02***(2006.01)i; ***C09J 5/00***(2006.01)i; ***H01L 21/683***(2006.01)i
FI: H01L21/304 622J; C09J4/02; C09J5/00; H01L21/68 N; H01L21/304 631

According to International Patent Classification (IPC) or to both national classification and IPC

### B. FIELDS SEARCHED

Minimum documentation searched (classification system followed by classification symbols)

H01L21/304; C09J4/02; C09J5/00; H01L21/683

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2021/235406 A1 (DENKA CO., LTD.) 25 November 2021 (2021-11-25) paragraphs [0047]-[0048], [0088]-[0095], [0112]-[0121] | 1-7 |
| A | JP 2023-008789 A (NIPPON STEEL CHEMICAL & MATERIAL CO., LTD.) 19 January 2023 (2023-01-19) entire text, all drawings | 1-7 |
| A | WO 2011/158654 A1 (DENKI KAGAKU KOGYO KABUSHIKI KAISHA) 22 December 2011 (2011-12-22) entire text, all drawings | 1-7 |
| A | JP 2016-086158 A (CENTRAL GLASS CO., LTD.) 19 May 2016 (2016-05-19) entire text, all drawings | 1-7 |
| A | JP 2006-188586 A (SEKISUI CHEMICAL CO., LTD.) 20 July 2006 (2006-07-20) entire text, all drawings | 1-7 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 March 2024** | **09 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/001572**

**C. DOCUMENTS CONSIDERED TO BE RELEVANT**

| Category* | Citation of document, with indication, where appropriate, of the relevant passages | Relevant to claim No. |
|---|---|---|
| A | JP 06-177094 A (MITSUI TOATSU CHEMICALS, INC.) 24 June 1994 (1994-06-24) entire text, all drawings | 1-7 |

Form PCT/ISA/210 (second sheet) (July 2022)

**INTERNATIONAL SEARCH REPORT**
**Information on patent family members**

International application No.
**PCT/JP2024/001572**

| Patent document cited in search report | Publication date (day/month/year) | Patent family member(s) | Publication date (day/month/year) |
|---|---|---|---|
| WO 2021/235406 A1 | 25 November 2021 | US 2023/0193090 A1<br>paragraphs [0057]-[0064], [0110]-[0121], [0140]-[0157]<br>EP 4148096 A1<br>TW 202200724 A<br>CN 115551962 A<br>KR 10-2023-0014687 A | |
| JP 2023-008789 A | 19 January 2023 | TW 202302788 A<br>CN 115141552 A<br>KR 10-2022-0136129 A | |
| WO 2011/158654 A1 | 22 December 2011 | US 2013/0092326 A1<br>entire text, all drawings<br>TW 201200545 A<br>CN 102947402 A<br>KR 10-2013-0095654 A | |
| JP 2016-086158 A | 19 May 2016 | (Family: none) | |
| JP 2006-188586 A | 20 July 2006 | (Family: none) | |
| JP 06-177094 A | 24 June 1994 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005159155 A